# EUROPEAN PATENT APPLICATION

(11) **EP 4 716 405 A1**
(43) Date of publication of application: **25.03.2026**
(21) Application number: 25199538.7
(22) Date of filing: 02.09.2025
(51) Int. Cl.: H10D 30/01, H10D 30/00

(54) **IMPROVED REMOVAL OF SACRIFICIAL MATERIAL FOR MINIMIZED CHANNEL EXTENSIONS**

(30) Priority: 24.09.2024 US 202418894650
(71) Applicant: INTEL Corporation, Santa Clara, CA 95054 (US)
(72) Inventor: ZHANG, Feng, Portland, 97229 (US); CHU, Tao, Portland, 97229 (US); XU, Guowei, Portland, 97229 (US); YEUNG, Chun Wing, Portland, 97229 (US); ZHANG, Kan, Hillsboro, 97123 (US); JANG, Minwoo, Portland, 97229 (US); LUO, Yanbin, Portland, 97229 (US); HUNG, Ting-Hsiang, Beaverton, 97007 (US); CHAO, Robin, Portland, 97209 (US); LIN, Chia-Ching, Portland, 97229 (US); LIN, Chung-Hsun, Portland, 97229 (US); ZHONG, Yue, Portland, 97229 (US); ZHANG, Yang, Rio Rancho, 87124 (US); PACKAN, Paul, Hillsboro, 97124 (US); MURTHY, Anand, Portland, 97229 (US)
(74) Representative: 2SPL Patentanwälte PartG mbB

(57) **Abstract**

Integrated circuit (IC) devices having dielectric spacers between parallel channel structures (e.g., of nanoribbons, nanowires, etc.).

A transistor structure may have first and second channel layers between source and drain bodies, a gate stack with a gate metal and gate dielectric between the channel layers, and a dielectric spacer between the channel layers and between the gate dielectric and one of the source and drain bodies. The dielectric spacer may have a significant (or minimal) curvature such that a width of the dielectric spacer between the channel layers is much greater (or not much greater) than widths of the dielectric spacer at the channel layers or than a minimum distance separating the gate metal between the channel layers from one of the source and drain bodies. An added or altered etch may remove sacrificial dummy gate material from between the channel layers and the gate side of the dielectric spacer.

## Description

### BACKGROUND

In conventional gate-all-around (GAA) field-effect transistors (FETs), multiple etches often leave residual sacrificial material adjacent channel structures (for example, between nanoribbon ends). This sacrificial residue may avoid removal first by dimple etches (e.g., recess etches of the sacrificial material between channel material layers), and then by channel-release etches (e.g., that should remove the remaining sacrificial material between channel material layers and between dimple spacer insulators at both ends of the channel material layers). This leftover sacrificial material may interfere with gate electrode formation (for example, with the filling of gate metal around channel structures and between dimple spacers). This interference may result in significant portions of the transistor channel that cannot be controlled by the gate, causing a large resistance of the channel extensions (those parts of the nanoribbons, etc., that are between the gate and the source and drain bodies) and limiting the on-state current. The sacrificial residue is commonly a material (such as a semiconductor material) that reduces isolation between the gate and the source and drain bodies, and so degrades yield.

New techniques, structures, and materials are needed to improve the shapes and relative dimensions of dimple spacers gate electrodes in GAA FETs.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIGS. 1A, 1B, 1C, 1D, 1E, and 1F illustrate cross-sectional profile views of integrated circuit (IC) devices having optimized gate structures and dimple spacers, for example, with minimized channel extensions, in accordance with some embodiments;
FIG. 2 is a flow chart of methods for forming optimized gate structures and dimple spacers, in accordance with some embodiments;
FIGS. 3A, 3B, 3C, 3D, 3E, 3F, 3G, 3H, and 3I illustrate cross-sectional profile views of a transistor structure having dimple spacers and a gate structure with optimized shapes in a workpiece or device, at various stages of manufacture, in accordance with some embodiments;
FIG. 4 illustrates a diagram of an example data server machine employing an IC device having enhanced dimple spacers and gate structure and minimized channel extensions, in accordance with some embodiments; and
FIG. 5 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Materials, structures, and techniques are disclosed to improve integrated circuit (IC) devices having dimple spacers between a gate electrode and source and drain bodies, e.g., in gate-all-around (GAA) field-effect transistors (FETs).

In conventional GAA FETs, layers of sacrificial material are often used during fabrication to support the channel material (for example, occupying space between layers of channel material) before source and drain bodies are epitaxially formed, coupling with and supporting the channel material layers. The sacrificial material layers may then be removed and replaced by a gate electrode over and between the channel material layers. First, a dimple etch may recess exposed sidewalls of the sacrificial material layers, and dimple spacers (e.g., dielectric insulators) may be formed in the recesses opened up by the dimple etch. After source and drain bodies are epitaxially grown from ends of the channel material layers (for example, nanoribbons, etc.), the remaining sacrificial material (e.g., between the dimple spacers) may be exposed, and removal may be attempted. For example, a sacrificial, "dummy" gate of a second material over the first sacrificial material may be removed, and the first sacrificial material may be selectively etched from between the channel material layers and from between the dimple spacers.

Often during the fabrication of conventional GAA FETs, sacrificial material is not completely removed between (e.g., on inner sidewalls of) the dimple spacers. Leftover sacrificial material may obstruct both formation of the gate electrode and isolation between the gate electrode and the epitaxial source and drain bodies ("source and drain epi"). By occupying space meant for gate metal and interfering with gate formation, sacrificial residue prevents complete electrostatic control of channel material adjacent the leftover sacrificial material, i.e., keeps the gate from turning that portion of the channel material on or off. This reduction of gate control may result in both increased "on" resistance and increased leakage current when the transistor should be off.

Compositional variations in the sacrificial material (e.g., concentration differences, such as a concentration gradient) may inhibit complete removal of the sacrificial material. For example, sacrificial material consisting of two elements (such as silicon and germanium) may have one or more concentration gradients between adjacent channel material layers, e.g., having a minimum concentration of germanium nearer the channel material layers and a maximum concentration of germanium at a vertical midpoint between the channel material layers. Selective etches leveraging the compositional differences in different portions of sacrificial material can be used to improve sacrificial material removal.

One or more etches may be added or improved to thoroughly remove sacrificial material and enable formation of optimally shaped dimple spacers and gate electrodes. In some embodiments, an optimized recess etch has a substantially flat etch front (which may enable tight and tightly controlled critical dimensions (CDs) between gate electrode and source and drain epi), and a subsequently formed dimple spacer has a substantially flat sidewall between channel material layers. A minimized dimple spacer width corresponds to a minimized length of channel material that is not between gate electrode (e.g., without electrostatic control).

In other embodiments, an optimized recess etch has a curved etch front, and a subsequently formed dimple spacer has a convex sidewall between channel material layers. The convex spacer allows a complementarily shaped gate electrode to extend towards the source and drain bodies, along the nanoribbons, etc., to maximize electrostatic control of the channel while maintaining distance from the epi between nanoribbons, etc., minimizing capacitance between the gate and epi. The dimple etch may utilize one or more etches (e.g., with one or more etch conditions) to control the etch shape, for example, by tailoring etch chemistries to a local composition of the sacrificial material or to the geometries of the structures to be etched.

Similarly, after dimple spacer formation, a channel-release etch may thoroughly remove the remaining sacrificial material between the spacers and between the channel layers using one or more added or improved etches, e.g., tailored to the local composition of the sacrificial material. For example, the etch may be tuned to the composition of the least accessible portions (e.g., nooks and crannies) of sacrificial material. In some embodiments, an added, separate etch may be performed, tuned to the least accessible portions of sacrificial material. The added or improved etch may ensure all remaining sacrificial material is removed, and that the extent of the subsequently formed gate electrode is maximized, for example, even into tight corners.

After channel release and before gate electrode formation, an optional dimple trim may be done on the inner (e.g., gate) side of the dimple spacers. An etch of the dimple spacer dielectric may trim the inner side of the spacer, for example, to reduce the dimensions (or alter the shape) of the spacer and the capacitance between the gate electrode and the source and drain epi.

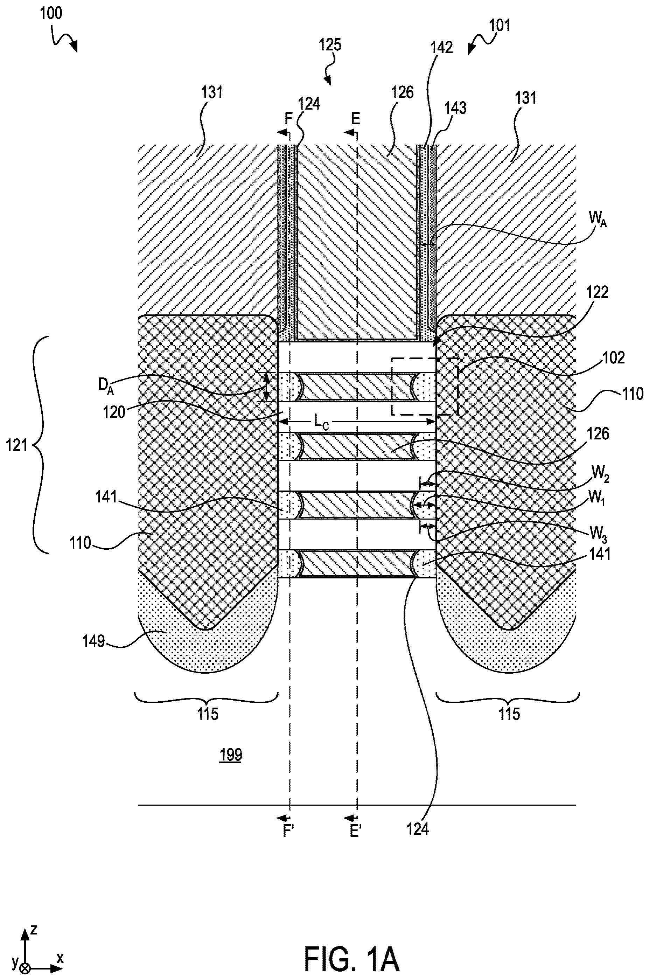

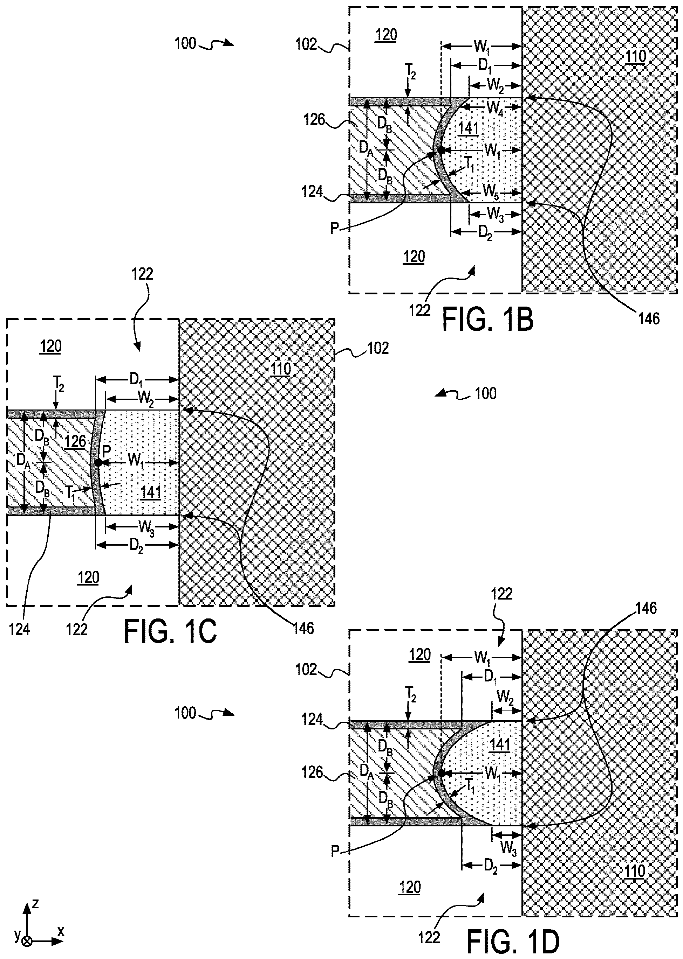

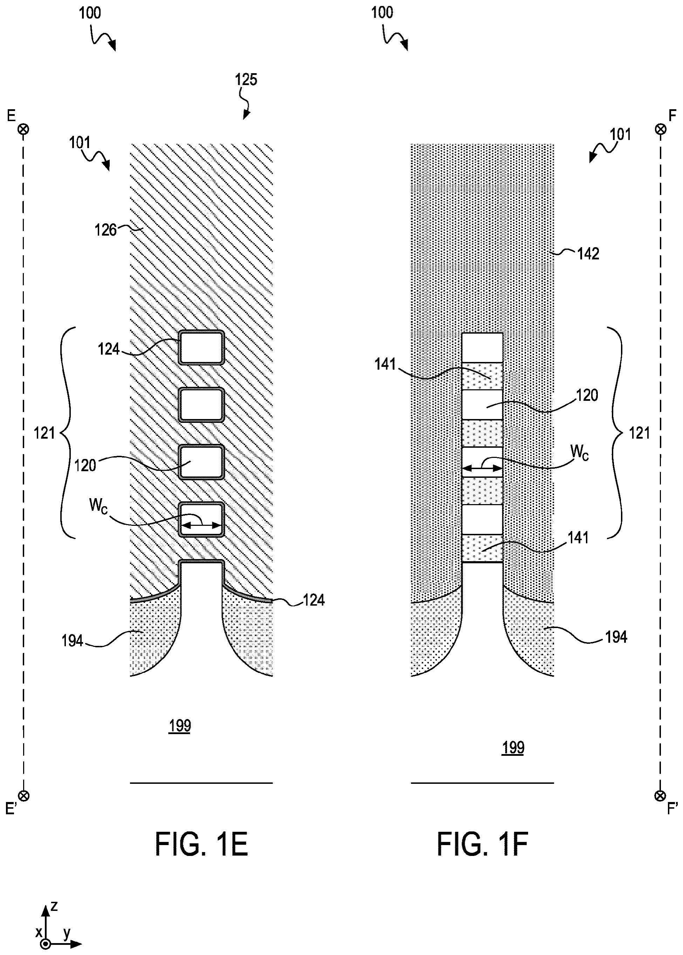

FIGS. 1A, 1B, 1C, 1D, 1E, and 1F illustrate cross-sectional profile views of IC devices 100 having optimized gate structures 125 and dimple spacers 141, for example, with minimized channel extensions 122, in accordance with some embodiments. FIGS. 1B, 1C, and 1D show in greater detail various alternative embodiments of inset view 102 of FIG. 1A. The orientation of y-z cross-sectional viewing planes E-E' and F-F' (through channel structures 120) of FIGS. 1E and 1F, respectively, are shown in the x-z cross-sectional view of FIG. 1A.

FIG. 1A shows a stack 121 of channel structures 120 between a pair of coupled source and drain bodies 110 in a transistor structure 101, e.g., a metal-oxide-semiconductor (MOS) FET structure 101. Source and drain bodies 110 are coupled by channel structures 120, which may be nanoribbons, nanowires, etc. Source and drain bodies 110 are separated by a channel length L_{C} of structures 120 (e.g., in the x-dimension). Transistor structure 101 includes gate structure 125 between source and drain bodies 110. Gate structure 125 includes a gate metal 126 and a gate insulator 124. Gate structure 125 (e.g., metal 126) is between each pair of channel structures 120. Gate insulator 124 is between gate metal 126 and each of channel structures 120 and between gate metal 126 and each of source and drain bodies 110. Each of source and drain bodies 110 is coupled by a contact structure 131 to an interconnect network over transistor structure 101.

Dimple spacers 141 (or gate-cavity spacers 141) are insulators between each of channel structures 120 and between gate structure 125 and each of source and drain bodies 110 (e.g., between gate insulator 124 and each of source and drain bodies 110). In some embodiments, dimple spacers 141 are below a lowermost channel structure 120 (as in the exemplary embodiment of FIG. 1A) and/or above an uppermost channel structure 120. Spacers 141 are each in contact with gate structure 125 (e.g., at gate insulator 124), one of a source or drain body 110, and at least one of channel structures 120.

Channel extensions 122 are those portions of channel structures 120 alongside spacers 141, between gate structure 125 and source and drain bodies 110 (e.g., not controlled by gate structure 125), where the resistance may be elevated. Advantageously, the length of extensions 122 (e.g., in the x-directions) are minimized. The total "on" resistance between source and drain bodies 110 is increased as the length of extensions 122 increase, e.g., if more of channel structures 120 are not controlled by gate structure 125. Although some portions (e.g., extensions 122) of structures 120 (nanoribbons, etc.) may not be electrostatically controlled by gate structure 125 (e.g., between structure 125 and source and drain bodies 110), the term "channel structures" is generally used here to refer to the entire length of the channel material layers (nanoribbons, etc.) between bodies 110.

Dimple spacers 141 may be of any suitable material(s). Spacers 141 are advantageously of a low-K ("low-permittivity") dielectric material, e.g., to minimize a capacitance between gate structure 125 and source and drain bodies 110. In many embodiments, spacers 141 include oxygen, for example, in an oxide (e.g., of silicon). Spacers 141 may have etch selectivities with low-K dielectric materials (such as spacers 142, 143, etc.) and so may have different compositions than other dielectric materials, compositions that balance various (e.g., chemical and electrical) properties (such as etch resistances and permittivity). In many embodiments, spacers 142 and/or 143 include oxygen, for example, in an oxide (e.g., of silicon). In some embodiments, spacers 142 and/or 143 include carbon, for example, as a dopant in an oxide (e.g., of silicon). In many embodiments, spacers 141 include nitrogen, for example, in a nitride (e.g., of silicon). In some embodiments, spacers 141 include oxygen and nitrogen, for example, in an oxynitride of silicon.

Spacers 141 are in substantially symmetrical pairs between each pair of channel structures 120, e.g., with one spacer 141 of each pair of spacers 141 on each of source and drain bodies 110 and with gate structure 125 between each pair of spacers 141. For example, a gate structure 125 may be between a pair of first and second spacers 141 (e.g., that are between a pair of first and second channel structures 120) with a first spacer 141 of the pair of spacers 141 on a source body 110 and a second spacer 141 of the pair of spacers 141 on a corresponding drain body 110. One of the first and second spacers 141 is between gate structure 125 (e.g., insulator 124) and one of source and drain bodies 110, and the other of the first and second spacers 141 is between gate structure 125 (e.g., insulator 124) and the other of source and drain bodies 110. In many embodiments, dimple spacers 141 are substantially identical, e.g., with matching dimensions, with some spacers 141 mirror-image instances of (e.g., symmetrical with) other spacers 141.

Dimple spacers 141 may have any suitable structure. In the exemplary embodiment of FIG. 1A, spacers 141 each have a longer first width W₁ between shorter second and third widths W₂, W₃. Width W₁ between interfaces 146 is greater than widths W₂, W₃ at interfaces 146 of spacers 141 with channel structures 120. For example, width W₁ may be about 6 nm, and widths W₂, W₃ may be less than 6 nm. Shorter widths W₂, W₃ correspond to shorter extensions 122 (and lower resistances of extensions 122). A longer width W₁ corresponds to advantageously lower capacitance between gate structure 125 and source and drain bodies 110. In the exemplary embodiment of FIG. 1A, width W₁ of spacer 141 is greater than six-fifths of widths W₂, W₃ of spacer 141. For example, width W₁ may be 6 nm, and widths W₂, W₃ may be less than 5 nm.

In many embodiments, width W₁ between shorter widths W₂, W₃ is at a height approximately equidistant between nearest channel structures 120. In many embodiments, widths W₂, W₃ at interfaces 146 of spacers 141 with channel structures 120 are equal. In some such embodiments, spacers 141 are symmetrical (e.g., about a horizontal line of symmetry in the x-directions) with equal widths W₂, W₃ at interfaces 146.

In some embodiments, widths W₂, W₃ at interfaces 146 are each less than or approximately equal to a width W_{A} of spacer(s) 142, 143. A same width W_{A}, W₂, W₃ of gate structure 125 on both sides of channel structures 120 means symmetrical operation (for example, electrostatic control by gate structure 125). In some embodiments, width W_{A} spans multiple spacers 142, 143. Spacer 142 is an insulator over an uppermost of channel structures 120. In some embodiments, spacer 143 is an additional electrical insulator layer, collectively forming an insulator over an uppermost of channel structures 120 with spacer 142. In some embodiments, spacer 143 is absent, and width W_{A} spans only spacer 142. In some embodiments, an additional dielectric spacer is adjacent spacer(s) 142 and/or 143, between contact structures 131 and spacers 142, 143, but width W_{A} includes only spacers 142, 143 (e.g., between gate structure 125 and a y-z plane aligned with the ends of structures 120). In some embodiments, width W₁ between interfaces 146 is approximately equal to width W_{A}, for example, when width W₁ is greater than widths W₂, W₃. In some embodiments, width W_{A} is greater than width W₁, which may correspond to shorter (and lower resistances of) extensions 122. Spacers 142, 143 may be sidewall spacers 142, 143 on sidewalls of gate structure 125 (e.g., on insulator 124). Channel structures 120 may extend (e.g., in the x-directions) through spacers 142, 143, which may extend in the y-directions along sidewalls of gate structure 125.

Widths W₁, W₂, W₃, etc., may have certain lengths (e.g., less than 6 nm) at certain nodes or in a particular process scheme, but relationships between widths W₁, W₂, W₃, etc., may be useful as transistor structures 101 are continually scaled down. In some embodiments, widths W₂, W₃ are each less than two-thirds of a distance D_{A} between channel structures 120. In some embodiments, width W₁ is less than two-thirds of distance D_{A} between channel structures 120.

In the exemplary embodiment of FIG. 1A, channel structures 120 are nanoribbon structures 120, layers of channel material (such as silicon or other semiconductor material) vertically aligned in stack 121, coupling source and drain bodies 110. Channel structures 120 may be channel material layers of any suitable material(s) or structure(s) in GAA FET structures 101. Channel structures 120 may be channel material layers in vertical stacks of any suitable number of layers, e.g., with multiple, vertically aligned channel layers in a single transistor structure 101. Stack 121 may include three, four, or any other suitable number of structures 120. Channel structures 120 may be channel material layers of any suitable width, such as nanowire channel structures 120 (e.g., of very narrow width), nanosheet channel structures 120 (e.g., of relatively wide width), nanoribbon channel structures 120 (e.g., of any intermediate width), etc. Channel structures 120 may be of any conductivity type (e.g., n- or p-type). In the example of FIG. 1A, multiple adjacent nanoribbon channel structures 120 of a same conductivity type (e.g., n- or p-type) extend in the x-directions.

In FIG. 1A, channel structures 120 are uniformly spaced, each separated from nearest structures 120 by distance D_{A}. In some embodiments, channel structures 120 may have other orientation(s). For example, in some embodiments, n- and p-type transistor structures 101 may be in a same stack 121 with some adjacent structures 120 separated by distance D_{A} and other adjacent structures 120 separated by some distance different than distance D_{A}. In such embodiments, some structures 120 may be coupled to different source and drain bodies 110 than other structures 120.

Gate structure 125 may include one or more dielectric (or other) materials in a gate insulator 124 on or over channel structures 120 and one or more electrode materials in a gate metal 126 on or over insulator 124. One or more gate metals 126 may be in a stack of layers between gate insulator 124 (on channel structure 120), for example, n- and p-type workfunction metals 126 advantageous for NMOS and PMOS structures 101, respectively. One or more gate metals 126 may be workfunction metals 126, particular to a type of gate structure 125, but gate structures 125 may include one or more metals 126 with no, negligible, or minimal workfunction effect, for example, used in either or gate structures 125 of either type.

In some embodiments, gate structure 125 includes a high-K (i.e., "high-permittivity") dielectric or ferroelectric material in insulator 124 advantageous for n-type transistor structures 101 and a workfunction metal 126 advantageous for n-type transistor structures 101. In some embodiments, gate structure 125 includes a high-K dielectric or ferroelectric material in insulator 124 advantageous for p-type transistor structures 101 and a workfunction metal 126 advantageous for p-type transistor structures 101. In some embodiments, gate structures 125 include gate insulators 124 with one or more (e.g., different) dipole dopants in structures 125. In many embodiments, gate insulators 124 include multiple layers of dielectric (and/or ferroelectric, etc.) materials, for example, a high-K dielectric layer over a passivation layer of a native oxide on channel structure 120.

Exemplary high-K dielectrics (e.g., in gate insulator 124) include metal oxides (e.g., including one or more of hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate), or metal silicates (e.g., including one or more of above metals, oxygen and silicon). Examples of workfunction metals 126 (e.g., in gate structure 125) include ruthenium, palladium, platinum, cobalt, nickel, and conductive metal oxides (e.g., ruthenium oxide), hafnium, zirconium, titanium, tantalum, aluminum, alloys of these metals, and carbides of these metals such as hafnium carbide, zirconium carbide, titanium carbide, tantalum carbide, and aluminum carbide.

In FIG. 1A, nanoribbon channel structures 120 extend in the x-directions (through gate structure 125) and couple to n- or p-type source and drain bodies 110. Channel structures 120 may be of corresponding n- or p-type (e.g., of a different material or structure that provides an increased mobility for a corresponding charge carrier type). Bodies 110 may include monocrystalline or polycrystalline semiconductor material, e.g., epitaxially grown in trenches 115 from ends of channel structures 120. Source and drain bodies 110 in an NMOS transistor structure 101 may include different materials than a PMOS transistor structure 101. For example, n-type source and drain bodies 110 in an NMOS transistor structure 101 may have chemical composition and microstructure suitable for an NMOS transistor structure 101. In many embodiments, n-type source and drain bodies 110 include a Group IV or III-V semiconductor material doped with any impurity dopants known to be suitable for the desired conductivity type, and to any concentration known to be suitable for transistors. In some embodiments, bodies 110A include silicon and an n-type dopant, such as phosphorous, arsenic, or another donor impurity.

P-type source and drain bodies 110 in a PMOS transistor structure 101 may have chemical composition and microstructure suitable for a PMOS transistor structure 101. In many embodiments, p-type source and drain bodies 110 include a Group IV or III-V semiconductor material doped with any impurity dopants known to be suitable for the desired conductivity type, and to any concentration known to be suitable for transistors. In some embodiments, p-type bodies 110 include silicon, germanium, and a p-type dopant, such as boron, aluminum, gallium or any other acceptor impurity. In some exemplary embodiments, n-type bodies 110 are predominantly silicon doped with any suitable concentration of donor impurities while p-type bodies 110 are predominantly silicon germanium doped with any suitable concentration of acceptor impurities.

One of source and drain bodies 110 is a source body 110, and the other of source and drain bodies 110 is a drain body 110. Bodies 110 may include or contact interface layers on contact structures 131. Interface layers may be alloyed layers (e.g., a silicide layer), for example, including a semiconductor material of body 110 and a metal. Each of source and drain bodies 110 is coupled by a metallized contact structure 131 to an interconnect network over transistor structure 101.

Substrate 199 may include any suitable material or materials. Any suitable semiconductor or other material can be used. Substrate 199 may be any suitable structure, such as a wafer, die, etc. Substrate 199 may include a semiconductor material that transistors can be formed out of and on, including a crystalline material, such as monocrystalline or polycrystalline silicon, germanium, silicon germanium, a III-V alloy material (e.g., gallium arsenide), a silicon carbide, a sapphire (e.g., Al₂O₃), or any combination thereof. In some embodiments, substrate 199 includes crystalline silicon and subsequent components are also silicon. Substrate 199 may be a silicon-on-insulator (SOI) substrate. Substrate 199 may refer specifically to a base material (for example, a thick base or layer of semiconductor material) that other materials (such as metals and dielectrics) are built up on. In some contexts, substrate 199 may refer to a base material layer and any build-up layers, etc., over the base. In some embodiments, a crystalline material of substrate 199 (e.g., an insulator or semiconductor material, such as silicon, etc.) is removed (e.g., by grinding) from a back side of substrate 199. In some such embodiments, further build-up layers (such as interconnect layers) may be formed on the back side of substrate 199. For example, subfins under channels 120 may be removed, and gate structures 125 (or other portions of transistor structures 101) may be coupled to a back-side interconnect layer. Substrate 199 may include semiconductor materials, metals, dielectrics, dopants, and other materials commonly found in IC substrates.

An isolation 149 (e.g., of low-K dielectric material, such as an oxide) may be around (e.g., under and to both sides of) source and drain bodies 110 (for example, in trenches 115 in substrate 199) and may provide electrical insulation between adjacent structures, for example, between bodies 110 and substrate 199.

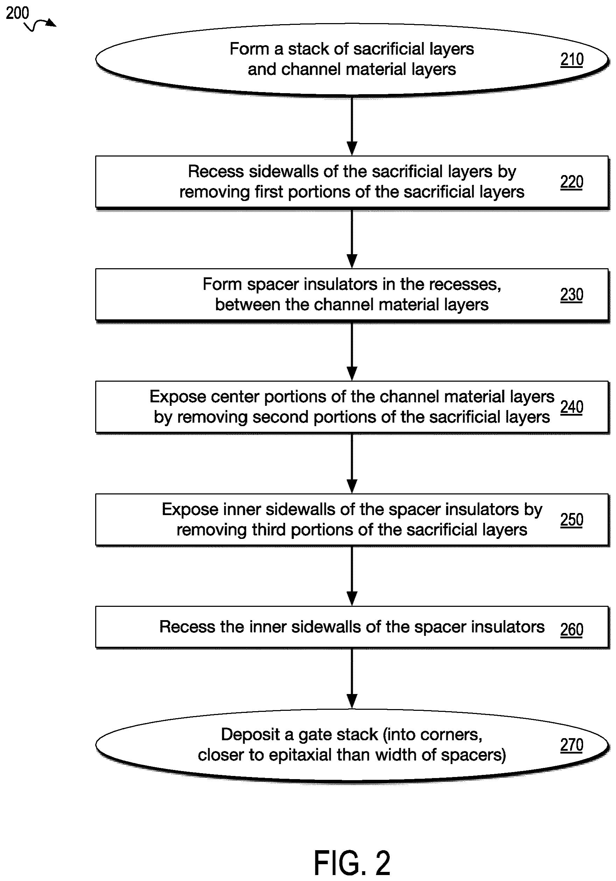

View 102 is of a single dimple spacer 141 between the uppermost channel structures 120, as well as adjacent structure 125 (including gate insulator 124 and metal 126) and source or drain body 110. View 102 is shown in greater detail and with alternate embodiments in FIGS. 1B, 1C, and 1D. Although some example embodiments are shown in FIGS. 1B-1D, other structures (e.g., shapes) of dimple spacers 141 are possible, for example, enabled by the operation and techniques of methods 200 described at least at FIG. 2. Although a single spacer 141 may be described with view 102 at each of FIGS. 1B-1D, IC device 100 may include a group (e.g., stack) of similar spacers 141, for example, a stack of pairs of dimple spacers 141, much as described at FIG. 1A.

FIG. 1B illustrates a cross-sectional profile view of optimized gate structure 125 and dimple spacer 141, in accordance with some embodiments. FIG. 1B shows detailed view 102 with a same or similar embodiment as that of FIG. 1A. Width W₁ of spacer 141 is between source or drain body 110 and a point P at an interface between spacer 141 and gate insulator 124 (e.g., where insulator 124 is on a sidewall of spacer 141). Gate insulator 124 is between (and in contact with) gate metal 126 and dimple spacer 141 and between (and in contact with) metal 126 and channel structures 120. Insulator 124 has a thickness T₁ between gate metal 126 and spacer 141. Insulator 124 has a thickness T₂ between metal 126 and structures 120. Distance D_{A} between channel structures 120 spans a thickness T₂ both above and below metal 126 between structures 120. In many embodiments, thicknesses T₁, T₂ are equal. Distance D_{B} is half of distance D_{A}. Width W₁ is at a height approximately equidistant between nearest channel structures 120 (e.g., at distance D_{B} from each of structures 120 and from each of interfaces 146 with widths W₂, W₃). Widths W₂, W₃ at interfaces 146 of spacer 141 with channel structures 120 are equal.

As shown in FIG. 1B (and as in FIG. 1A), IC device 100 has dimple spacers 141 with a width W₁ greater than widths W₂, W₃ at interfaces 146 of spacer 141 with channel structures 120. Gate metal 126 of structure 125 is within a distance D₁ of source or drain body 110 over point P, and metal 126 is within a distance D₂ of body 110 under point P. In many embodiments, distances D₁, D₂ are equal. Width W₁ is greater than first and second distances D₁, D₂ separating gate metal 126 from body 110. Distance D₁ is adjacent the uppermost channel structure 120 and above point P and width W₁. Distance D₂ is adjacent the next-to-uppermost channel structure 120 and below point P and width W₁. Distances D₁, D₂ separating gate metal 126 from source or drain body 110 include intermediate widths W₄, W₃, respectively, as well as a portion of distances D₁, D₂ through gate insulator 124 at least slightly greater thickness T₁ (e.g., because of the oblique path through insulator 124).

Width W₁ is greater than five-fourths of widths W₂, W₃ and greater than six-fifths of distances D₁, D₂, which may provide a large width W₁ (and correspondingly low capacitance) while providing short widths W₂, W₃ (and correspondingly low resistance of channel structures 120 and extensions 122). For example, width W₁ may be 5 nm, and widths W₂, W₃ may be less than 4 nm. In many embodiments, width W₁ of spacer 141 is greater than six-fifths of widths W₂, W₃ and greater than seven-sixths of distances D₁, D₂, which may simultaneously allow for sufficiently short widths W₂, W₃ (but sufficiently thick width W₁) while limiting process variations, e.g., of widths W₂, W₃. Excessive curvature of spacer 141 may make process control of widths W₂, W₃ difficult and lead to too much process variation. Also, large curvatures and so large differences (between width W₁ and widths W₂, W₃) may make for sharper (e.g., acuter) internal corners, which may be difficult to clear of sacrificial material.

Other dimensions and relationships may be used to characterize the curvature of dimple spacers 141. Width W₁ is greater than distances D₁, D₂ separating metal 126 from body 110, and the difference between width W₁ and distances D₁, D₂ is greater than thickness T₁ between gate metal 126 and spacer 141 (e.g., width W₁ > distance D₁ plus thickness T₁, and width W₁ > distance D₂ plus thickness T₁). In some embodiments, dimple spacer 141 has a greater curvature, and the difference between width W₁ and distances D₁, D₂ is greater still. Advantageously, distances D₁, D₂ (e.g., the portion of channel structures 120 between gate metal 126 and source or drain body 110) are minimized, but the curvature of spacer 141 may be limited by a desire to limit process variations and to maintain width W₂ approximately equal to width W_{A} of spacer(s) 142, 143 (as described at FIG. 1A) over an uppermost of channel structures 120. In some embodiments, widths W₂, W₃ are approximately equal to width W_{A}. In some embodiments, widths W₂, W₃ are slightly less than width W_{A}, e.g., when spacer 141 has greater curvature.

In many embodiments, distance D_{A} between channel structures 120 is greater than width W₁ of spacer 141. In some such embodiments, two-thirds of distance D_{A} is greater than widths W₂, W₃ of spacer 141 (and widths W₂, W₃ are each less than two-thirds of distance D_{A}). In some such embodiments, two-thirds of distance D_{A} is greater than distances D₁, D₂ separating metal 126 from body 110 (and distances D₁, D₂ are each less than two-thirds of distance D_{A}). In some such embodiments, two-thirds of distance D_{A} is greater than width W₁ of spacer 141 (and width W₁ is less than two-thirds of distance D_{A}).

FIG. 1C shows a cross-sectional profile view of optimized gate structure 125 and dimple spacer 141, in accordance with some embodiments. FIG. 1C shows detailed view 102 with a flatter-profiled (e.g., more-rectangular) embodiment of spacer 141 than that of FIGS. 1A and 1B, for example, with a smaller difference between width W₁ and widths W₂, W₃. A flatter, more-rectangular dimple spacer 141 (e.g., with less curvature from width W₁ to widths W₂, W₃) may maximize performance of transistor structure 101 and/or device 100, for example, by minimizing gate-epi capacitance for a given width W₁ and in embodiments where operating speed is a priority. A more-rectangular spacer 141 may maximize a minimum isolation distance (e.g., widths W₂, W₃, separating gate metal 126 from source or drain body 110) for a given maximum isolation distance (e.g., width W₁) and minimize corresponding capacitance between metal 126 and body 110.

Spacer 141 may have a substantially rectangular profile. In some embodiments, width W₁ is approximately equal to widths W₂, W₃. Such minimal curvature, e.g., with width W₁ and widths W₂, W₃ being approximately equal, may be required to attain smallest CDs and minimal process variation, as previously described. In some embodiments, spacer 141 has some curvature with, for example, distance D₁ (or D₂) greater than width W₁. Such minimal curvature may allow for sufficiently small CDs and an allowable amount of process variation. Curvature of spacer 141 may still be minimal. For example, in some embodiments, width W₁ is greater than widths W₂, W₃, but by less than a thickness T₁ of gate insulator 124 between gate metal 126 and spacer 141, e.g., width W₁ < width W₂ (or W₃) plus thickness T₁. In some embodiments, distance D₁ (or D₂) is greater than width W₁, but by less than a thickness T₁ of gate insulator 124, e.g., distance D₁ < width W₁ plus thickness T₁. This minimal curvature may provide tolerably small capacitance while still allowing for acceptably inexpensive processing (e.g., in time or money costs).

FIG. 1D illustrates a cross-sectional profile view of optimized gate structure 125 and dimple spacer 141, in accordance with some embodiments. FIG. 1D shows detailed view 102 with a more tightly curved (or more-convex) embodiment of spacer 141 than that of FIGS. 1A and 1B, for example, with a larger difference between width W₁ and widths W₂, W₃. Widths W₂, W₃ are shorter than in the embodiment of FIG. 1B. Note that, in some embodiments, spacer 141 has a larger difference between width W₁ and widths W₂, W₃, but with widths W₂, W₃ approximately equal to those in the embodiment of FIG. 1B and with width W₁ greater than that of the embodiment of FIG. 1B.

Width W₁ is greater than distances D₁, D₂ separating gate metal 126 from source or drain body 110, and the difference between width W₁ and distances D₁, D₂ is greater than twice the thickness T₁ between metal 126 and spacer 141 (e.g., width W₁ > distance D₁ plus two times thickness T₁, and width W₁ > distance D₂ plus two times thickness T₁). Width W₁ is greater than four-thirds of widths W₂, W₃ and greater than five-fourths of distances D₁, D₂. The deep, convex spacer 141 may provide the desired dimensions and aspect ratio (e.g., minimizing the length and resistance of extension 122) and may enable (or be enabled by) a quick etch (e.g., less costly in processing time or other costs).

In some embodiments, width W₁ is greater than distances D₁, D₂ separating metal 126 from body 110, and the difference between width W₁ and distances D₁, D₂ is greater than three times the thickness T₁ between metal 126 and spacer 141 (e.g., width W₁ > distance D₁ plus three times thickness T₁, and width W₁ > distance D₂ plus three times thickness T₁). In some embodiments, width W₁ is greater than three-halves of widths W₂, W₃ and greater than four-thirds of distances D₁, D₂. The deeper, more-convex spacer 141 may further minimize the length and resistance of extension 122 (e.g., for the same width W₁) or minimize the capacitance between metal 126 and body 110 (e.g., for the same distances D₁, D₂).

FIGS. 1E and 1F show transverse cross-sectional profile views of channel structures 120, including through gate structure 125 and with dimple spacers 141 between channel structures 120, in accordance with some embodiments. As shown at FIG. 1A, the y-z cross-sectional viewing planes E-E' of FIG. 1E and F-F' of FIG. 1F are through gate structure 125 and spacers 141, 142, respectively. Note that FIGS. 1E and 1F are not necessarily to scale and that channel structures 120 may be of any suitable size. For example, instead of nanoribbon channel structures 120, in some embodiments, structures 120 are nanowire structures 120 with narrower widths W_{C} or nanosheet structures 120 with narrower widths W_{C}.

FIG. 1E illustrates stack 121 of channel structures 120 through gate structure 125, in accordance with some embodiments. The y-z plane E-E' of FIG. 1E is through channel structures 120 at about a longitudinal midpoint of structures 120. Approximately equal transverse channel widths W_{C} of channel structures 120 are shared with a subfin of substrate 199 under stack 121. Gate insulator 124 is between gate metal 126 and each of channel structures 120. Metal 126 is between each of channel structures 120. An isolation 194 (e.g., of low-K dielectric material, such as an oxide) may be over substrate 199 (e.g., under gate structure 125 and to both sides of a subfin of substrate 199) and may provide electrical insulation between adjacent structures, for example, between stacks 121 and subfins of substrate 199.

FIG. 1F shows stack 121 of channel structures 120 through spacers 141, 142, in accordance with some embodiments. The y-z plane F-F' of FIG. 1F is through channel structures 120 between gate structure 125 and a source or drain body 110. Approximately equal transverse channel widths W_{C} of channel structures 120 are shared with a subfin of substrate 199 under stack 121. Channel structures 120 extend in the x-directions through sidewall spacer 142. Spacer 142 may be a sidewall spacer 142 on a sidewall of gate structure 125. Channel structures 120 extend in the x-directions through spacer 142, which extends in the y- and z-directions on the sidewall of structure 125. Dimple spacers 141 are between each of channel structures 120, and spacer 142 is to both sides (e.g., in both y-directions) of stack 121 and spacers 141. A lowermost of spacers 141 is below a lowermost of channel structures 120, between the lowermost of channel structures 120 and the subfin of substrate 199. Isolation 194 is over substrate 199, e.g., under sidewall spacer 142 and to both sides of the subfin of substrate 199. Isolation 194 may provide electrical insulation between adjacent structures, for example, between stacks 121 and subfins of substrate 199.

FIG. 2 is a flow chart of methods 200 for forming optimized gate structures and dimple spacers, in accordance with some embodiments. Methods 200 include operations 210-270. Some operations shown in FIG. 2 are optional. Additional operations may be included. FIG. 2 shows an example sequence, but the operations can be done in other orders as well, and some operations may be omitted. Some operations can also be performed multiple times before other operations are performed. Some operations may be included within other operations so that the number of operations illustrated FIG. 2 is not a limitation of the methods 200.

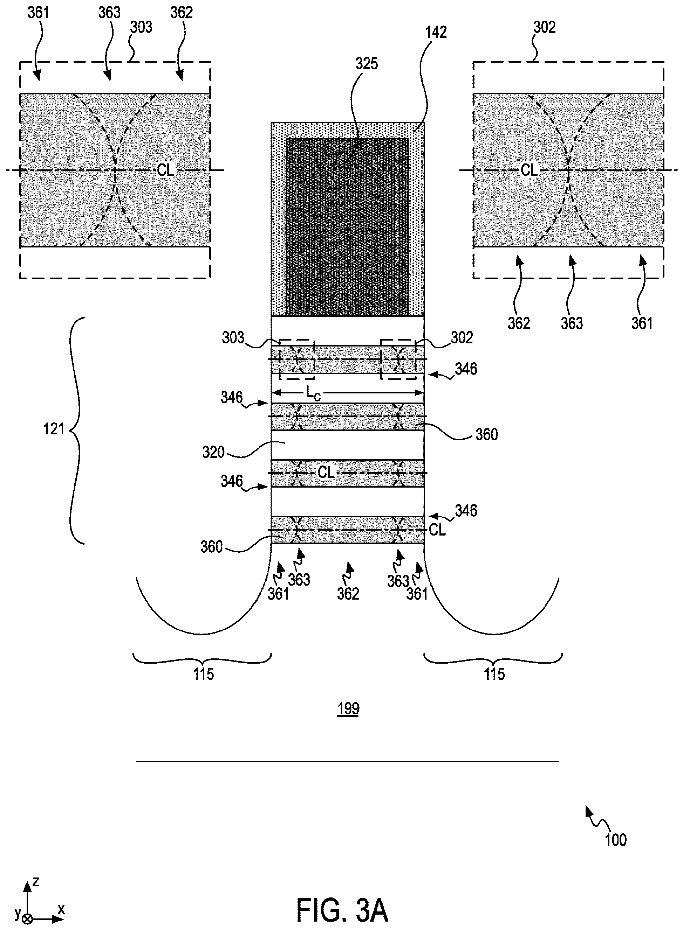

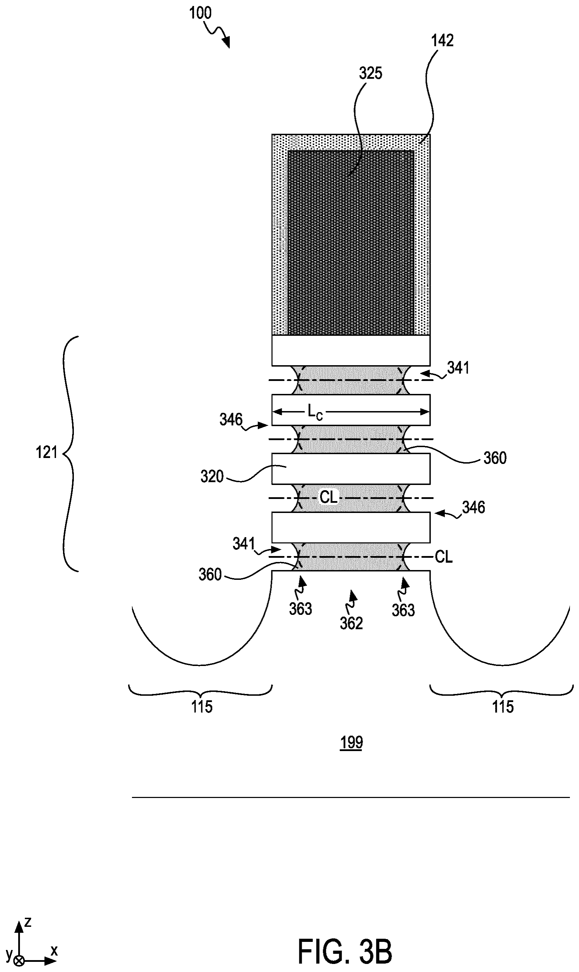

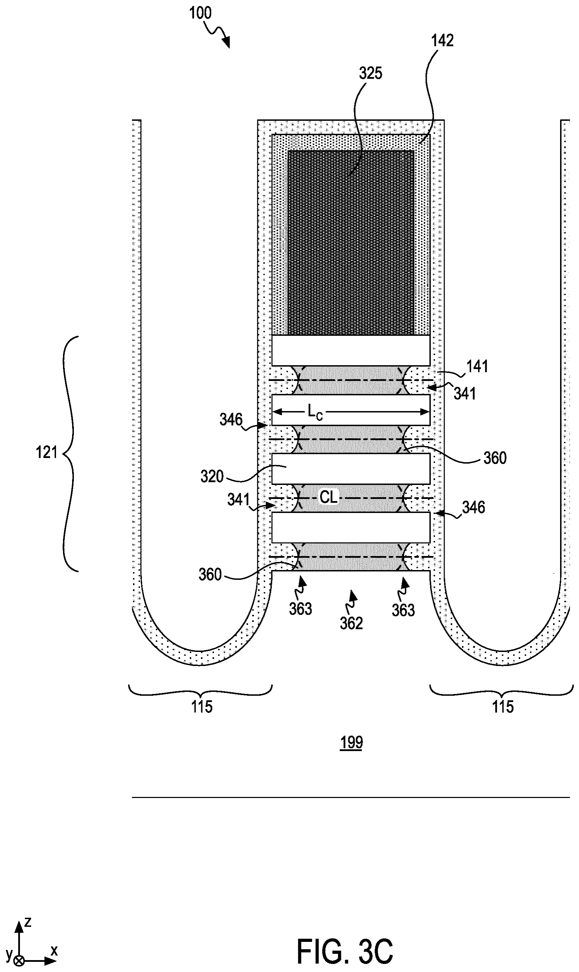

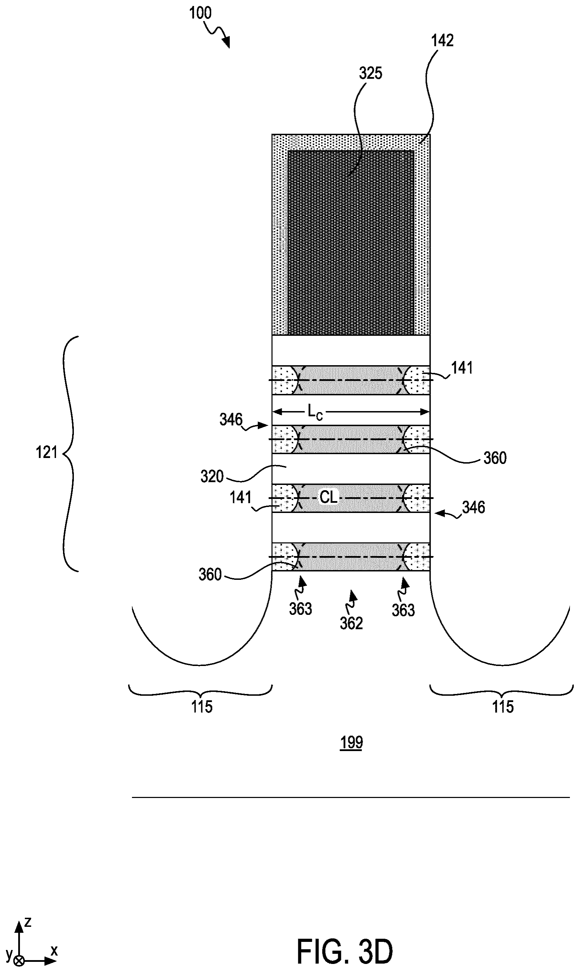

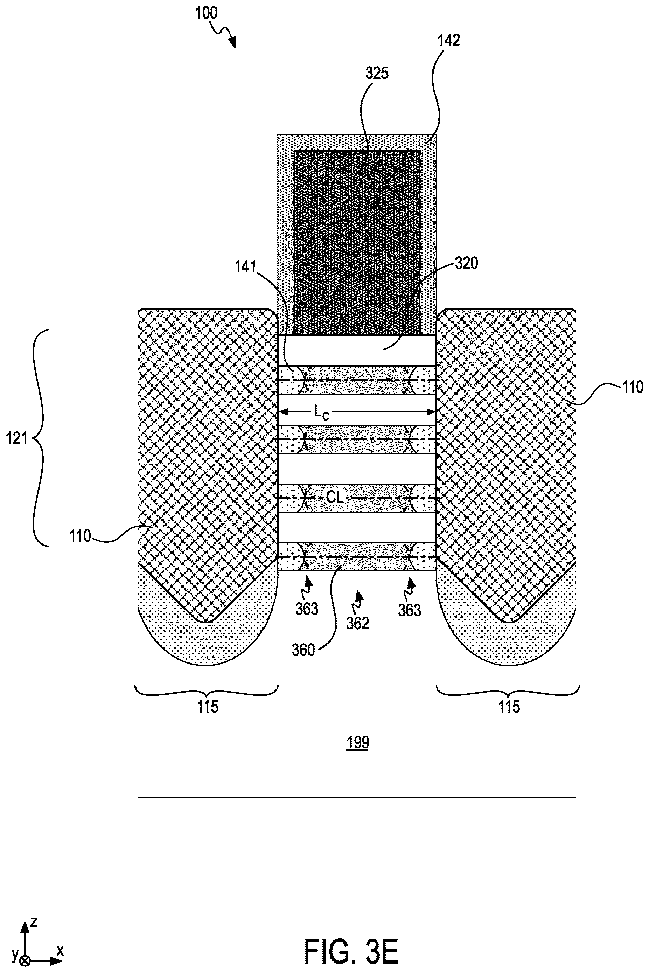

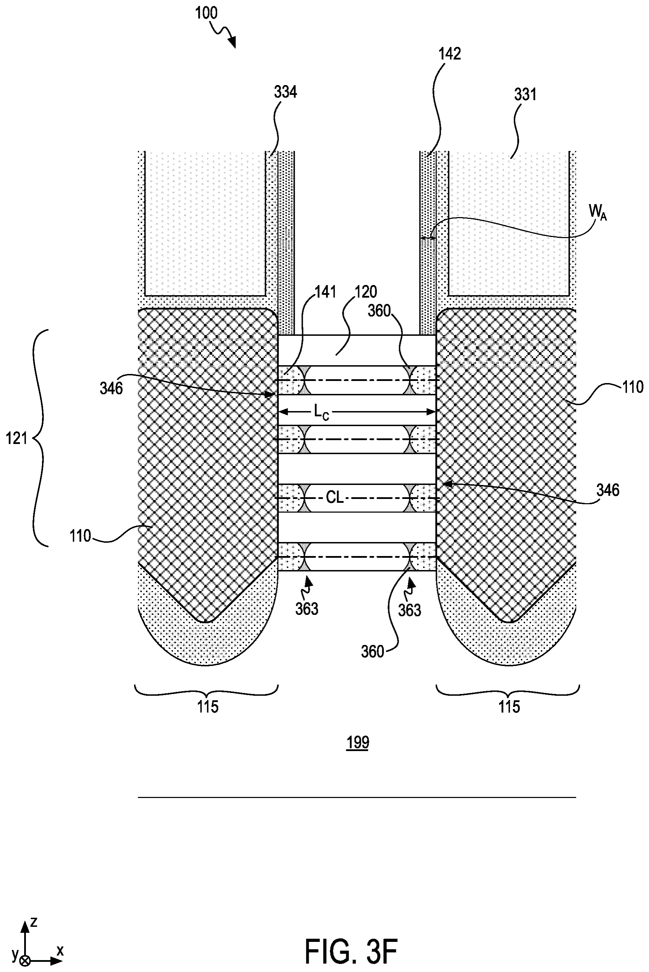

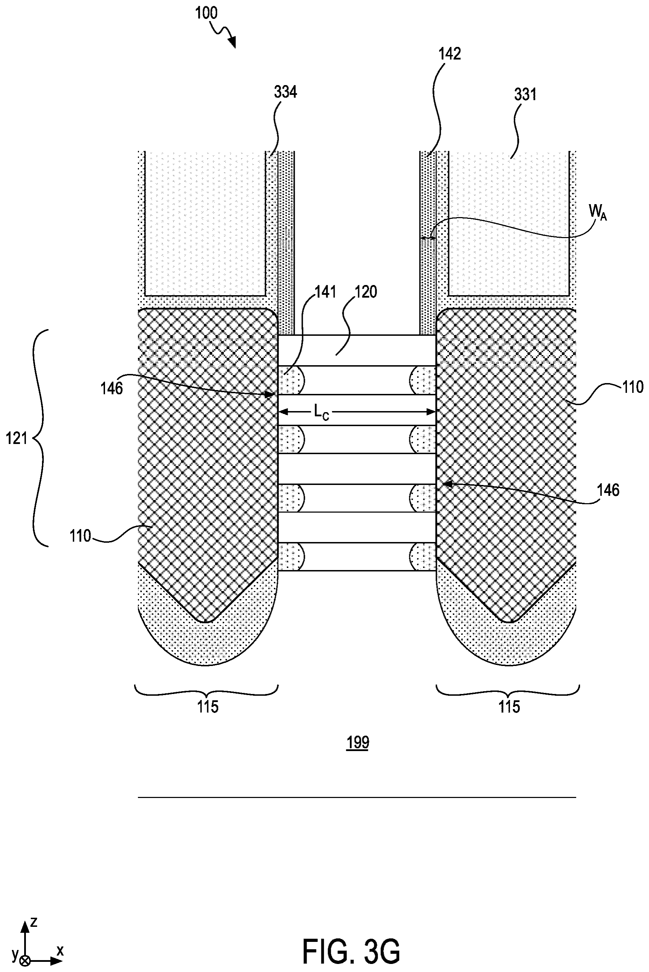

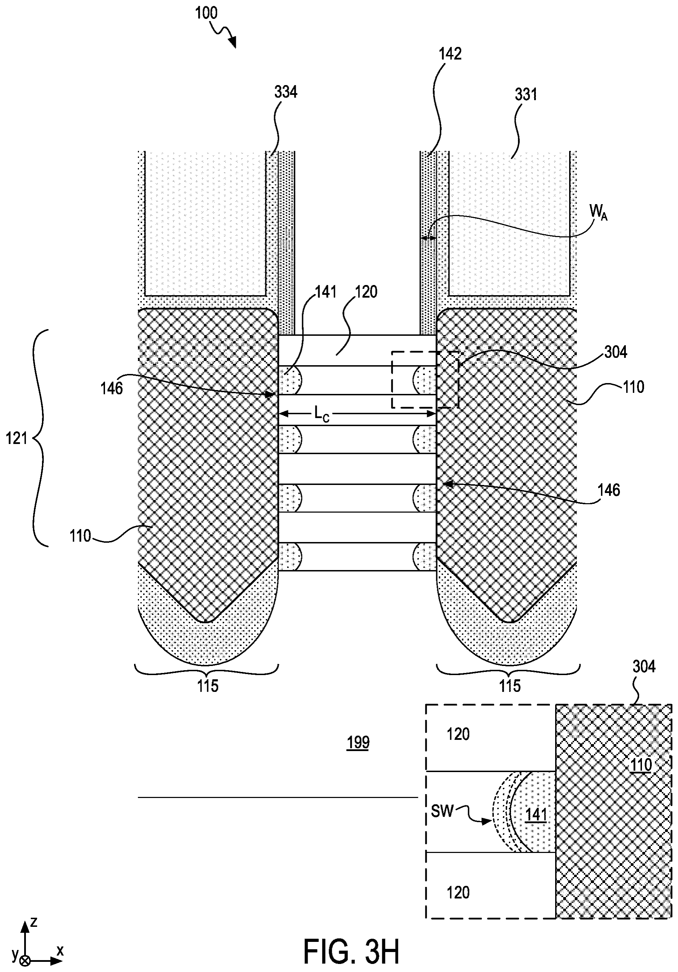

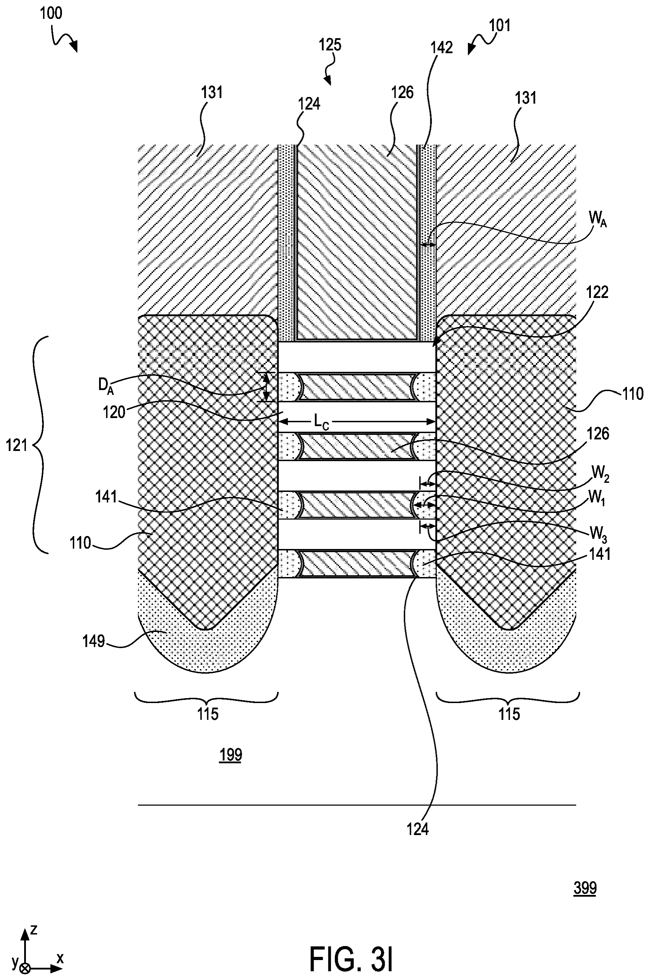

FIGS. 3A, 3B, 3C, 3D, 3E, 3F, 3G, 3H, and 3I illustrate cross-sectional profile views of transistor structure 101 having dimple spacers 141 and gate structure 125 with optimized shapes in a workpiece or device 100, at various stages of manufacture, in accordance with some embodiments. FIGS. 3A-3I show possible examples of intermediate structures during an embodiment of a practice of methods 200 of FIG. 2.

Returning to FIG. 2, methods 200 begin at operation 210 with forming a stack of sacrificial layers and channel material layers. The stack of layers may be formed by any suitable means, for example, by epitaxially growing (e.g., depositing) the layers in an alternating fashion over a substrate. The stack may be formed to have any suitable number of layers, e.g., two, three, four, or more channel material layers (to form four channel structures, such as nanoribbons) and two, three, four, or more sacrificial layers (below, between, and perhaps above the channel material layers).

The stack of layers may be formed of any suitable material(s), for example, a first (e.g., semiconductor) material and a second material having an etch selectivity with the first material. The channel material layers may be any suitable (e.g., semiconductor) material(s) (for example, elemental, alloyed, compound, etc.). In many embodiments, the channel material layers are of silicon and/or germanium. In some embodiments, the sacrificial layers are of silicon and/or germanium. In some embodiments, the channel material layers are of silicon, and the sacrificial layers are of silicon germanium.

The sacrificial layers may be formed (for example, as initially deposited or following subsequent processing) with one or more compositional variations within each sacrificial layer. Compositional variations in the sacrificial material (e.g., concentration differences, such as a concentration gradient) may affect etch selectivities of the sacrificial material. For example, sacrificial material consisting of two elements (such as silicon and germanium) may have one or more concentration gradients between adjacent channel material layers, e.g., having a minimum concentration of germanium at the interfaces with the channel material layers and a maximum concentration of germanium at a midpoint of the sacrificial layer between the channel material layers. In other embodiments, a sacrificial layer has a maximum concentration of germanium at interfaces with the channel material layers and a minimum concentration of germanium at a midpoint of the sacrificial layer between the channel material layers. In still other embodiments, a sacrificial material includes two elements at least one of which is not silicon or germanium, and the sacrificial layer has some positional compositional differences.

In some embodiments, the sacrificial layers include silicon and germanium. In some such embodiments, the sacrificial layers have different first and second compositions at first and second locations in the sacrificial layers, a first composition at interfaces of the sacrificial layers with the channel material layers and a second composition between the channel material layers (e.g., near a centerline or axis running the length of the sacrificial layer). In some such embodiments, the first and second compositions differ with the germanium concentrations of the first and second compositions being at least ten percent (of the total concentration) different. For example, in some embodiments, a first composition at interfaces of the sacrificial and channel material layers has germanium as less than 25% of the total concentration, and a second composition near a centerline of the sacrificial layer has germanium as more than 35% of the total concentration. In other embodiments, a first composition at interfaces of the sacrificial and channel material layers has germanium as more than 45% of the total concentration, and a second composition near a centerline of the sacrificial layer has germanium as less than 30% of the total concentration. The compositional differences may subsequently be utilized to shape etches of the sacrificial material.

After the stack of channel material and sacrificial layers is formed, both sets of interleaved layers may be cut (e.g., etched) into stacks of smaller segments, for example, fins having a channel length in one dimension. Such an etch may form trenches in the substrate, and each trench may be a channel length from other nearest adjacent trenches, e.g., with the trenches separating stacks of channel (and sacrificial) layers. The trench-cut etches may be through the layers after a dummy gate is deposited over the stack of layers, and the dummy gate may act as a mask material, covering the fin to be retained and leaving exposed the portions of the layers to be removed. In many embodiments, the dummy gate is a sacrificial material (e.g., polysilicon) that has an etch selectivity with the channel and sacrificial materials and that occupies space that will later be filled by a gate electrode.

FIG. 3A illustrates stack 121 of channel material and sacrificial layers 320, 360 in a workpiece or device 100, in accordance with some embodiments, for example, following a performance of forming operation 210. Stack 121 is between trenches 115 in substrate 199 and includes channel material layers 320 and sacrificial layers 360. Layers 320, 360 have length L_{C} between trenches 115. Sacrificial gate 325 is over stack 121, and spacer 142 is a layer over dummy gate 325. Sidewalls of spacer 142 may be sidewalls of trenches 115, e.g., in the y-directions from (e.g., in front of and behind) the x-z viewing plane. In some embodiments, a second spacer layer is over dummy gate 325.

Sacrificial material layers 360 include first, second, and third portions 361, 362, 363, which are delineated by dashed lines, e.g., for illustrative purposes. Other dashed lines CL are centerlines CL (e.g., axes) of layers 360. In some embodiments, sacrificial layers 360 have different compositions (e.g., concentrations) at centerlines CL and at interfaces 346 of layers 360 with channel material layers 320.

Magnified views 302, 303 show portions 361, 362, 363 on both sides (e.g., in the x-directions) of an example sacrificial layer 360. First portions 361 of sacrificial layers 360 may later be removed first, from ends of layers 360 at trenches 115. Second portions 362 may be removed next, from the center of layers 360, for example, after dimple spacers replace first portions 361 and following a removal of dummy gate 325 over stack 121. Third portions 363 may be removed, for example, from a gate side of dimple spacers after second portions 362 are cleared out.

Returning to FIG. 2, methods 200 continue at operation 220 by removing first portions of the sacrificial layers between the channel material layers in the stack. In many embodiments, the second and third portions of the sacrificial layers are retained, for example, by an etch selective to the second and third portions that removes the first portions. In many embodiments, the first portions include sidewalls of the sacrificial layers, the second portions are between pairs of the first portions, and the third portions are adjacent interfaces of the channel material layers between the first and second portions.

A selective etch may be employed to remove the first portions of the sacrificial layers. The etch may be selective to (e.g., the etch retains) the channel material layers and removes exposed sacrificial material, recessing the sacrificial layers until the first portions of the sacrificial layers are removed. The selectivity of the recess etch may be dependent on the composition of the sacrificial material, for example, removing sacrificial material more or less quickly depending on the composition of the sacrificial material. In many embodiments, the removing the first portions of the sacrificial layers includes etching at a first rate adjacent one or more centerlines of sacrificial layers and etching at a second rate adjacent the channel material layers. In some such embodiments, the first etch rate is greater than the second etch rate. In other embodiments, the second etch rate is greater than the first etch rate. For example, in embodiments with a silicon germanium sacrificial material, the germanium concentration may be higher (or lower) adjacent the centerline of a sacrificial layer and lower (or higher) adjacent channel material layers over and under the sacrificial layer, and the etch rates may differ at the different locations and depend on the germanium concentration of the sacrificial material at the different locations.

The composition-dependent etch selectivities may be employed to shape the etch front of the recess etch. In some embodiments, a single set of etch conditions (including etch chemistry, e.g., of etch reactants) is used, and the different etch rates are utilized concurrently in a single etch. For example, an etch chemistry that is tuned to remove a higher (or lower) germanium (or other sacrificial constituent) concentration adjacent channel material layers over and under the sacrificial layer at a higher rate may be used to recess the sacrificial layers with a substantially flat etch front. In some embodiments, a first set of etch conditions is used to remove a lower (or higher) germanium (or other) concentration at a sacrificial layer centerline, and then a second set of etch conditions is used to remove a higher (or lower) germanium (or other) concentration adjacent channel material layers over and under the sacrificial layer to recess the sacrificial layers with a substantially flat etch front. In one exemplary embodiment, a single etch is employed to remove at a high rate a higher (or lower) germanium (or other) concentration at a sacrificial layer centerline and to form a dimple recess with high curvature.

FIG. 3B illustrates stack 121 of channel material layers 320 and (second and third portions 362, 363 of) sacrificial layers 360 in workpiece or device 100, in accordance with some embodiments, for example, following a performance of removing operation 220. Dimple recesses 341 in sacrificial layers 360 are between channel layers 320 and in place of absent first portions 361 of layers 360. Dimple recesses 341 in sacrificial layers 360 exhibit a curvature, for example, having an etch front deeper into sacrificial layer 360 at centerlines CL then at interfaces 346 of layers 320, 360.

Returning to FIG. 2, methods 200 continue at operation 230 with forming a group of dimple spacers. The dimple spacers are spacer electrical insulators that will be between the eventual gate electrode and the eventual source and drain bodies, for example, between the channel material layers. The dimple spacers may be formed by any suitable means. In many embodiments, the dimple spacers are formed by depositing a dielectric material between the channel material layers in the stack, adjacent the second and third portions of the sacrificial layers. The dielectric material may be deposited by any suitable means. In many embodiments, the dielectric material is conformally deposited over the stack of layers, including in dimple recesses between the channel material layers, which replaces the removed first portions of sacrificial material.

Excess dielectric material over the stack of layers may be removed by any suitable means. In many embodiments, dielectric material is isotropically removed, and only dielectric material sheltered in the dimple recesses between the channel material layers is retained.

Source and drain bodies may be grown from ends of the channel material layers (for example, nanoribbons, etc.). The source and drain bodies may be of high-quality crystalline semiconductor material, e.g., epitaxially grown from crystalline lattices of the channel material. The source and drain bodies may provide mechanical support for the channel material layers and so enable the removal of the remaining second and third portions of the sacrificial material. Dielectric fill deposited in the trenches, over and around the source and drain bodies, may provide further mechanical support for structures on the substrate, e.g., prior to and during subsequent removal operations and to enable CMP (chemical-mechanical planarization or polish) operations of the substrate.

FIG. 3C shows a layer of spacer 141 in dimple recesses 341 and over channel material and sacrificial layers 320, 360 in a workpiece or IC device 100, in accordance with some embodiments, for example, following a performance of forming operation 230. Spacer 141 is a conformal layer, on sidewalls of layers 320, 360 and replacing first portions 361 of sacrificial layers 360.

FIG. 3D illustrates dimple spacers 141 between channel material layers 320 and adjacent sacrificial layers 360 in stack 121 in a workpiece or IC device 100, in accordance with some embodiments, for example, following a performance of forming operation 230. No excess dielectric material is present on sidewalls of layers 320, 360. Dimple spacers 141 are adjacent sacrificial layers 360 and are confined to between channel material layers 320.

FIG. 3E shows dimple spacers 141 on source and drain bodies 110 and between channel material layers 320 coupling between source and drain bodies 110 in a workpiece or IC device 100, in accordance with some embodiments, for example, following a performance of forming operation 230. Bodies 110 are in trenches 115, and channel material layers 320 are coupled between bodies 110, mechanically supported.

Returning to FIG. 2, methods 200 continue by exposing center portions of the channel material layers at operation 240. In many embodiments, the center portions of the channel material layers are exposed between the insulators by removing the second portions of the sacrificial layers between the third portions, for example, by a channel-release etch. In many embodiments, removing the second portions of the sacrificial layers includes first removing a sacrificial dummy gate over the stack of channel and sacrificial layers. The removal of the dummy gate may be by any suitable means, for example, by a wet chemical etch of polysilicon. The dummy gate may first be exposed for etching by a CMP of a spacer layer over the dummy gate. A layer of dielectric on the stack (e.g., a passivation layer), exposed by removal of the dummy gate, may also be removed (e.g., to expose the second portions of sacrificial material) before the second portions are removed.

The removal of the second portions of sacrificial material may be by any suitable means, e.g., by an etch with conditions similar to a recess etch of sacrificial material at operation 220. For example, a dry isotropic etch may be employed to remove the sacrificial material between the channel material layers. As at operation 220, the etch may be tuned to the composition of the sacrificial material to be removed, whatever the composition. The one or more etches removing the second portions may be very selective to the channel material layers. For example, the etch(es) may be so selective to the channel material layers that exposed portions of the channel material layers and portions of the channel material layers covered, e.g., by spacers, may share perfectly flat surfaces (such as sidewalls, tops, and bottoms), aligned with a crystalline lattice of the channel material.

FIG. 3F illustrates second portions of sacrificial layers 360 absent and third portions 363 of sacrificial material remaining on dimple spacers 141 in a workpiece or IC device 100, in accordance with some embodiments, for example, following a performance of exposing operation 240. Dimple spacers 141 are on source and drain bodies 110 between released channel structures 120. Third portions 363 of sacrificial layers 360 remain between channel structures 120, on dimple spacers 141. Sidewalls of third portions 363 of sacrificial layers 360 exhibit a curvature (e.g., from etches that removed second portions of layers 360), for example, having an etch front deeper into sacrificial layer 360 at centerlines CL then at interfaces 346 of layers 320, 360.

Dielectric fill 331 is over source and drain bodies 110. Dielectric layer 334 is on spacer 142 and on source and drain bodies 110. Dielectric fill 331 is on and within layer 334. Some of layer 334 may subsequently be retained, e.g., on spacer 142 when contact structures are on bodies 110, but note that width W_{A} spans spacer 142 but not layer 334.

Returning to FIG. 2, methods 200 continue with removing the third portions at operation 250. The third portions may be removed adjacent the dimple spacers and the channel material layers. For example, the third portions may be residual portions of the sacrificial layers on the gate side of the dimple spacers and on the channel material layers (e.g., at interfaces of the sacrificial layers with the channel material layers). The removal of the third portions of sacrificial material may be by any suitable means, e.g., by an etch with conditions similar to a recess etch of sacrificial material at operation 220. For example, an isotropic plasma etch may be employed to remove residual third portions of the sacrificial layers (e.g., at interfaces of the sacrificial layers with the channel material layers, on the gate side of the dimple spacers). The one or more etches removing the third portions may be very selective to the channel material layers. For example, the etch(es) may be so selective to the channel material layers that exposed portions of the channel material layers and portions of the channel material layers covered, e.g., by spacers, may share perfectly flat surfaces (such as sidewalls, tops, and bottoms), aligned with a crystalline lattice of the channel material.

As at operation 220, the etch may be tuned to the composition of the sacrificial material to be removed. The etch may use one or more etch conditions (e.g., an etch chemistry) different from that of an etch removing second portions of the sacrificial layers at operation 240. The removal of the third portions may expose sidewalls of the dimple spacers (e.g., further expose sidewalls partially exposed by the removal of the second portions), sidewalls adjacent center portions of the channel material layers (e.g., on the gate side of the dimple spacers) and opposite the sidewalls of the dimple spacers on the source and drain bodies, adjacent end portions of the channel material layers. In many embodiments, an etch removing third portions of the sacrificial material is somewhat selective to the second portions of the sacrificial material, and an etch removing the second portions is somewhat selective to the third portions. In some embodiments, removing the third portions of the sacrificial layers includes etching at a first rate adjacent the channel material layers and etching at a second rate adjacent a centerline of the sacrificial layers. In some embodiments, the first etch rate is greater the second etch rate.

FIG. 3G shows sacrificial layers 360 completely absent and dimple spacers 141 exposed between channel structures 120 in a workpiece or IC device 100, in accordance with some embodiments, for example, following a performance of removing operation 250. Channel structures 120 are released, exposed between spacers 141, 142, prepared for the formation of a gate electrode over channel structures 120. Dimple spacers 141 are also exposed on the gate side, opposite source and drain bodies 110, between channel structures 120, available for further processing.

Returning to FIG. 2, methods 200 continue with optionally recessing gate-side sidewalls of the dimple spacers at operation 260. The dimple spacer sidewalls may be recessed by any suitable means, e.g., with an isotropic, dry etch that retains adjacent structures and selectively removes the exposed dielectric material of the dimple spacers. Besides the gate-side sidewalls of the dimple spacers, the dimple spacers may be covered, e.g., by source or drain bodies and by sidewall spacers (such as spacer(s) 142, 143, as described at least at FIG. 1A). The one or more etches recessing the dimple spacers may be very selective to the channel material layers. For example, the etch(es) may be so selective to the channel material layers that exposed portions of the channel material layers and portions of the channel material layers covered, e.g., by spacers, may share perfectly flat surfaces (such as sidewalls, tops, and bottoms), aligned with a crystalline lattice of the channel material.

An etch of the dimple spacers may flatten the dimple spacers, e.g., reducing the width of the dimple spacers and/or reducing a curvature of a convex dimple spacer. In some embodiments, recessing the dimple spacers (e.g., at gate-side sidewalls) reduces a width of the dimple spacers (e.g., width W₁, as described at least at FIGS. 1A and 1B) to less than or approximately equal to a width of a sidewall spacer over an uppermost of the channel material layers (e.g., width W_{A} of spacer(s) 142 and/or 143, as described at least at FIG. 1A). In some embodiments, recessing the dimple spacer reduces a width of the dimple spacer (e.g., width W₁, as described at least at FIGS. 1A and 1B) to less than or approximately equal to a height of the dimple spacer (e.g., distance D_{A}, as described at least at FIG. 1B).

FIG. 3H illustrates dimple spacers 141 (including with multiple alternate sidewalls SW shown in detailed view 304) exposed between channel structures 120 in a workpiece or IC device 100, in accordance with some embodiments, for example, following a performance of recessing operation 260.

The dimensions of dimple spacers 141 may be adjusted (e.g., at recessing operation 260), for example, to provide the structures described elsewhere herein, such as at FIGS. 1A-1D. Detailed view 304 shows multiple alternate sidewalls SW that may be achieved (or, e.g., may be intermediate structures during a performance of methods 200). Dashed lines may illustrate previous or possible alternative extents of spacer 141. For example, spacer 141 may have a shortest width and least extent (e.g., with the solid-lined sidewall SW) following a recess from a widest width and greatest extent (left-most dashed-line sidewall SW). As another example, spacer 141 may have an intermediate width and flatter curvature (e.g., with the middle dashed-line sidewall SW) following a recess from a widest width and greatest extent (left-most dashed-line sidewall SW).

Returning to FIG. 2, methods 200 continue with depositing a gate stack between the dimple spacers and between the channel material layers at operation 270. In many embodiments, the gate stack includes a gate insulator (such as a high-K dielectric) and a gate metal on the gate insulator. The gate insulator may be on the channel material layers (e.g., conformally), or on a passivation layer on the channel material layers, and the gate metal may be on the gate insulator (e.g., contained within a conformal layer of the gate insulator).

The thorough removal of sacrificial material (e.g., in difficult-to-access nooks, crannies, etc., for example, adjacent convex dimple spacers) may enable the deployment of gate metal at advantageous locations. In some embodiments, the depositing the gate stack deposits the gate metal to within a distance of a source or drain body (e.g., either of distances D₁, D₂, as described at least at FIG. 1B), and a width of a dimple spacer between the gate metal and the source or drain body (e.g., width W₁, as described at least at FIGS. 1A and 1B) is greater than the distance. In some such embodiments, the width is greater than six-fifths (or five-fourths or four-thirds, etc.) of the distance, e.g., as described at least at FIGS. 1B and 1D. The elevated proportions achieved with higher and higher widths and/or shorter and shorter distances may provide the advantages described at FIGS. 1B and 1D (such as reduced capacitance and/or increased gate control and correspondingly lower extension resistance).

The optional trimming of the dielectric material of dimple spacers (e.g., at gate-side sidewalls) may enable the deployment of gate metal at advantageous locations. For example, in some embodiments, the depositing the gate stack deposits the gate metal to within a distance of a source or drain body (e.g., either of distances D₁, D₂, as described at least at FIGS. 1B and 1C), and a width of a dimple spacer between the gate metal and the source or drain body (e.g., width W₁, as described at least at FIGS. 1A-1C) is greater than widths of the dimple spacer at interfaces with abutting channel layers (e.g., widths W₂, W₃, as described at least at FIGS. 1A-1C) but by less than a thickness of a gate insulator between a gate metal and the dimple spacer (e.g., thickness T₁, as described at least at FIGS. 1B and 1C). In some embodiments, the distance (e.g., either of distances D₁, D₂, as described at least at FIGS. 1B and 1C) is greater than width W₁, but by less than a thickness T₁ of gate insulator.

FIG. 3I shows a cross-sectional profile view of IC device 100 having optimized dimple spacers 141 and gate structure 125 and minimized channel extensions 122, in accordance with some embodiments. Dimple spacers 141 have desired curvature and dimensions, such as widths W₁, W₂, W₃, etc. Channel extensions 122 may be minimized, for example, thanks to minimized widths W₂, W₃. Gate stack or structure 125 may be as previously described (e.g., at least at FIG. 1A), e.g., with insulator 124 conformally on dimple spacers 141. Contact structures 131 couple bodies 110.

IC device 100 and substrate 199 may be coupled to host component 399 and to a power supply through host component 399. Host component 399 is a planar platform and may include dielectric and metallization structures. Host component 399 mechanically supports and electrically couples one or more IC devices 100. At least one side of host component 399 includes substrate interconnect interfaces for bonding to one or more IC devices 100. IC device 100 may be direct bonded, e.g., hybrid bonded, to host component 399 or otherwise bonded, e.g., by optional solder bumps. The opposite side of host component 399 may include similar interfaces, e.g., copper pads for socketing and/or solder bumps for bonding device 100 to a host component, such as a printed circuit board (PCB). Host component 399 may be any host component with substrate interconnect interfaces, such as a package host component 399 or interposer, another IC die, etc. Host component 399 may itself be a die. In many embodiments, host component 399 includes organic dielectric(s), such as a resin or other polymer, between metallization layers.

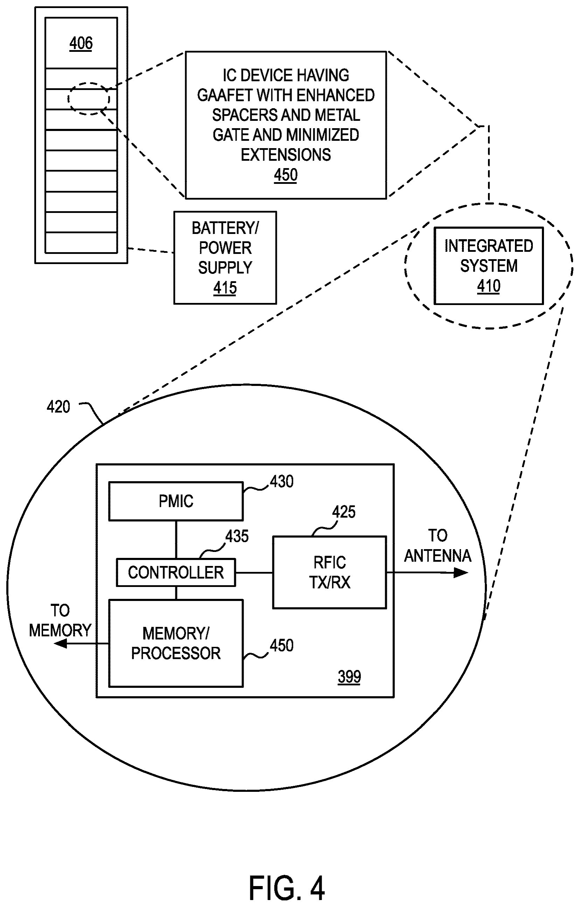

FIG. 4 illustrates a diagram of an example data server machine 406 employing an IC device having enhanced dimple spacers and gate structure and minimized channel extensions, in accordance with some embodiments, e.g., formed by multiple channel-release etches and removals of sacrificial materials. Server machine 406 may be any commercial server, for example, including any number of high-performance computing platforms disposed within a rack and networked together for electronic data processing, which in the exemplary embodiment includes one or more devices 450 having enhanced dimple spacers and gate structure.

Also as shown, server machine 406 includes a battery and/or power supply 415 to provide power to devices 450, and to provide, in some embodiments, power delivery functions such as power regulation. Devices 450 may be deployed as part of a package-level integrated system 410. Integrated system 410 is further illustrated in the expanded view 420. In the exemplary embodiment, devices 450 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 450 is a microprocessor including a static RAM (SRAM) cache memory. As shown, device 450 may be an IC device having enhanced dimple spacers and gate structure, as discussed herein. Device 450 may be further coupled to (e.g., communicatively coupled to) a board, an interposer, or other host component 399 along with, one or more of a power management IC (PMIC) 430, RF (wireless) IC (RFIC) 425 including a wideband RF (wireless) transmitter and/or receiver (TX/RX) (e.g., including a digital baseband and an analog front end module further includes a power amplifier on a transmit path and a low noise amplifier on a receive path), and a controller 435 thereof. In some embodiments, RFIC 425, PMIC 430, controller 435, and device 450 include having enhanced dimple spacers and gate structure.

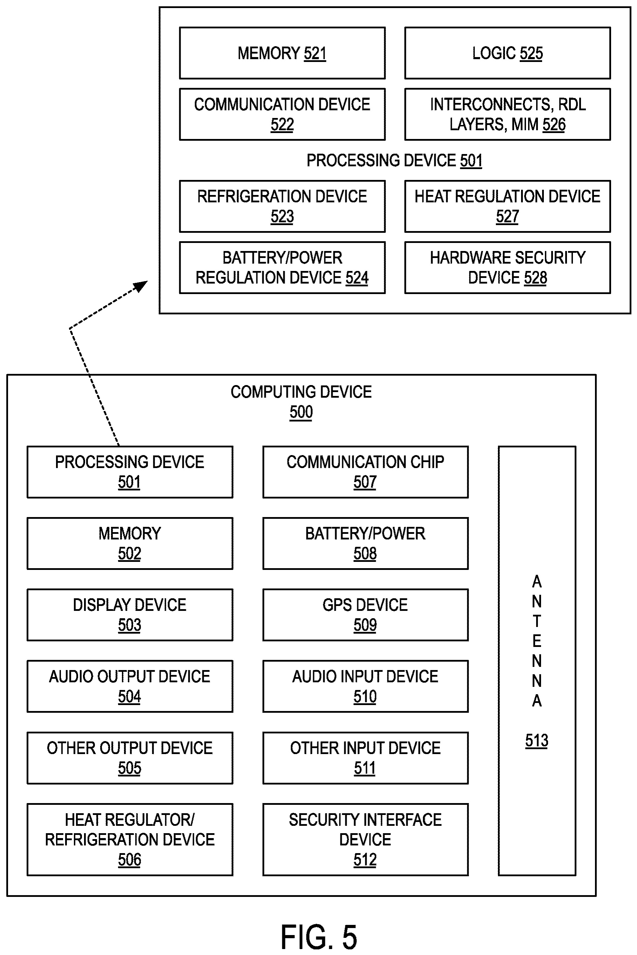

FIG. 5 is a block diagram of an example computing device 500, in accordance with some embodiments. For example, one or more components of computing device 500 may include any of the devices or structures discussed herein. A number of components are illustrated in FIG. 5 as being included in computing device 500, but any one or more of these components may be omitted or duplicated, as suitable for the application. In some embodiments, some or all of the components included in computing device 500 may be attached to one or more printed circuit boards (e.g., a motherboard). In some embodiments, various ones of these components may be fabricated onto a single system-on-a-chip (SoC) die. Additionally, in various embodiments, computing device 500 may not include one or more of the components illustrated in FIG. 5, but computing device 500 may include interface circuitry for coupling to the one or more components. For example, computing device 500 may not include a display device 503, but may include display device interface circuitry (e.g., a connector and driver circuitry) to which display device 503 may be coupled. In another set of examples, computing device 500 may not include an audio output device 504, other output device 505, global positioning system (GPS) device 509, audio input device 510, or other input device 511, but may include audio output device interface circuitry, other output device interface circuitry, GPS device interface circuitry, audio input device interface circuitry, audio input device interface circuitry, to which audio output device 504, other output device 505, GPS device 509, audio input device 510, or other input device 511 may be coupled.

Computing device 500 may include a processing device 501 (e.g., one or more processing devices). As used herein, the term "processing device" or "processor" indicates a device that processes electronic data from registers and/or memory to transform that electronic data into other electronic data that may be stored in registers and/or memory. Processing device 501 may include a memory 521, a communication device 522, a refrigeration device 523, a battery/power regulation device 524, logic 525, interconnects 526 (i.e., optionally including redistribution layers (RDL) or metal-insulator-metal (MIM) devices), a heat regulation device 527, and a hardware security device 528.

Processing device 501 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 500 may include a memory 502, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 502 includes memory that shares a die with processing device 501. This memory may be used as cache memory and may include embedded dynamic random-access memory (eDRAM) or spin transfer torque magnetic random-access memory (STT-MRAM).

Computing device 500 may include a heat regulation/refrigeration device 506. Heat regulation/refrigeration device 506 may maintain processing device 501 (and/or other components of computing device 500) at a predetermined low temperature during operation.

In some embodiments, computing device 500 may include a communication chip 507 (e.g., one or more communication chips). For example, the communication chip 507 may be configured for managing wireless communications for the transfer of data to and from computing device 500. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 507 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 507 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 507 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 507 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 507 may operate in accordance with other wireless protocols in other embodiments. Computing device 500 may include an antenna 513 to facilitate wireless communications and/or to receive other wireless communications (such as AM or FM radio transmissions).

In some embodiments, communication chip 507 may manage wired communications, such as electrical, optical, or any other suitable communication protocols (e.g., the Ethernet). As noted above, communication chip 507 may include multiple communication chips. For instance, a first communication chip 507 may be dedicated to shorter-range wireless communications such as Wi-Fi or Bluetooth, and a second communication chip 507 may be dedicated to longer-range wireless communications such as GPS, EDGE, GPRS, CDMA, WiMAX, LTE, EV-DO, or others. In some embodiments, a first communication chip 507 may be dedicated to wireless communications, and a second communication chip 507 may be dedicated to wired communications.

Computing device 500 may include battery/power circuitry 508. Battery/power circuitry 508 may include one or more energy storage devices (e.g., batteries or capacitors) and/or circuitry for coupling components of computing device 500 to an energy source separate from computing device 500 (e.g., AC line power).

Computing device 500 may include a display device 503 (or corresponding interface circuitry, as discussed above). Display device 503 may include any visual indicators, such as a heads-up display, a computer monitor, a projector, a touchscreen display, a liquid crystal display (LCD), a light-emitting diode display, or a flat panel display, for example.

Computing device 500 may include an audio output device 504 (or corresponding interface circuitry, as discussed above). Audio output device 504 may include any device that generates an audible indicator, such as speakers, headsets, or earbuds, for example.

Computing device 500 may include an audio input device 510 (or corresponding interface circuitry, as discussed above). Audio input device 510 may include any device that generates a signal representative of a sound, such as microphones, microphone arrays, or digital instruments (e.g., instruments having a musical instrument digital interface (MIDI) output).

Computing device 500 may include a GPS device 509 (or corresponding interface circuitry, as discussed above). GPS device 509 may be in communication with a satellite-based system and may receive a location of computing device 500, as known in the art.

Computing device 500 may include other output device 505 (or corresponding interface circuitry, as discussed above). Examples of the other output device 505 may include an audio codec, a video codec, a printer, a wired or wireless transmitter for providing information to other devices, or an additional storage device.

Computing device 500 may include other input device 511 (or corresponding interface circuitry, as discussed above). Examples of the other input device 511 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 500 may include a security interface device 512. Security interface device 512 may include any device that provides security measures for computing device 500 such as intrusion detection, biometric validation, security encode or decode, access list management, malware detection, or spyware detection.

Computing device 500, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1A-5. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes first and second channel material layers between source and drain bodies in a transistor structure, a gate stack between the source and drain bodies, the gate stack including a gate metal and a gate dielectric, the gate metal between the first and second channel material layers, the gate dielectric between the gate metal and the first and second channel material layers and between the gate metal and the source and drain bodies, and an insulator between the first and second channel material layers and between the gate dielectric and a first of the source and drain bodies, wherein the insulator has a first width between the first and second channel material layers greater than six-fifths of a second width of the insulator at an interface with the first channel material layer.

In one or more second embodiments, further to the first embodiments, the first width is at a height approximately equidistant from the first and second channel material layers, the interface of the insulator with the first channel material layer is a first interface, a third width of the insulator is at a second interface with the second channel material layer, and the second and third widths are approximately equal.

In one or more third embodiments, further to the first or second embodiments, the second and third widths are each less than or approximately equal to a fourth width of a second insulator over an uppermost of the first and second channel material layers.

In one or more fourth embodiments, further to the first through third embodiments, the second and third widths are each less than two-thirds of a distance between the first and second channel material layers.

In one or more fifth embodiments, further to the first through fourth embodiments, the first width is less than two-thirds of the distance between the first and second channel material layers.

In one or more sixth embodiments, further to the first through fifth embodiments, the first width of the insulator is greater than first and second distances separating the gate metal from the first of the source and drain bodies, the first distance is adjacent the first channel material layer and above the first width, and the second distance is adjacent the second channel material layer and below the first width.

In one or more seventh embodiments, further to the first through sixth embodiments, a stack of nanoribbons includes the first and second channel material layers, the insulator is a first of a plurality of insulators, the gate stack is between pairs of the plurality of insulators, and a second of the plurality of insulators is between the first and second channel material layers and between the gate dielectric and a second of the source and drain bodies.

In one or more eighth embodiments, an apparatus includes first and second channel material layers between source and drain bodies in a transistor structure, a gate stack between the source and drain bodies, the gate stack including a gate metal and a gate dielectric, the gate metal between the first and second channel material layers, the gate dielectric between the gate metal and the first and second channel material layers and between the gate metal and the source and drain bodies, and an insulator between the first and second channel material layers and between the gate dielectric and a first of the source and drain bodies, wherein the insulator has a width at a height equidistant from the first channel material layer above the width and the second channel material layer below the width greater than a sum of a thickness of the gate dielectric between the gate metal and the insulator and a distance separating the gate metal from the first of the source and drain bodies.

In one or more ninth embodiments, further to the eighth embodiments, the distance separating the gate metal from the first of the source and drain bodies is a first distance, and a second distance separating the first and second channel material layers is greater than the width of the insulator.

In one or more tenth embodiments, further to the eighth or ninth embodiments, the width is a first width, a second width of the insulator is at an interface with the first channel material layer, and the second width is less than or approximately equal to a third width of a second insulator over an uppermost of the first and second channel material layers.

In one or more eleventh embodiments, further to the eighth through tenth embodiments, the first width is greater than six-fifths of the second width.

In one or more twelfth embodiments, further to the eighth through eleventh embodiments, a stack of nanoribbons includes the first and second channel material layers, the insulator is a first of a plurality of insulators, the gate stack is between pairs of the plurality of insulators, and a second of the plurality of insulators is between the first and second channel material layers and between the gate dielectric and a second of the source and drain bodies.

In one or more thirteenth embodiments, a method includes removing first portions of sacrificial layers between channel material layers in a stack, the first portions including sidewalls of the sacrificial layers, wherein second and third portions of the sacrificial layers are retained, the second portions are between the first portions, and the third portions are adjacent interfaces of the channel material layers between the first and second portions, forming a plurality of insulators by depositing a dielectric adjacent the second and third portions of the sacrificial layers, between the channel material layers in the stack, exposing center portions of the channel material layers between the insulators by removing the second portions of the sacrificial layers between the third portions, and removing the third portions adjacent the insulators and the interfaces of the channel material layers.

In one or more fourteenth embodiments, further to the thirteenth embodiments, the removing the third portions adjacent the insulators and the interfaces of the channel material layers exposes first sidewalls of the insulators, the first sidewalls adjacent the center portions of the channel material layers and opposite second sidewalls of the insulators adjacent end portions of the channel material layers, and the method also includes recessing the first sidewalls of the insulators.

In one or more fifteenth embodiments, further to the thirteenth or fourteenth embodiments, the insulators are first insulators, and the recessing the first sidewalls of the insulators reduces a first width of a first of the first insulators to less than or approximately equal to a second width of a second insulator over an uppermost of the channel material layers.

In one or more sixteenth embodiments, further to the thirteenth through fifteenth embodiments, the recessing the first sidewalls of the insulators reduces a width of a first of the insulators to less than or approximately equal to a height of the first of the insulators between adjacent first and second channel material layers.

In one or more seventeenth embodiments, further to the thirteenth through sixteenth embodiments, the removing the first portions of the sacrificial layers includes etching at a first rate adjacent a centerline of a first of the sacrificial layers greater than a second rate adjacent the channel material layers.

In one or more eighteenth embodiments, further to the thirteenth through seventeenth embodiments, the removing the third portions of the sacrificial layers includes etching at a first rate adjacent the channel material layers greater than a second rate adjacent a centerline of a first of the sacrificial layers.

In one or more nineteenth embodiments, further to the thirteenth through eighteenth embodiments, the method also including depositing a gate stack between the plurality of insulators and between the channel material layers, wherein the gate stack includes a gate metal, the depositing the gate stack deposits the gate metal to within a distance of a source or drain body, and a width of a first of the insulators between the gate metal and the source or drain body is greater than the distance.

In one or more twentieth embodiments, further to the thirteenth through nineteenth embodiments, the method also including forming the stack of sacrificial layers and channel material layers, wherein a first of the sacrificial layers includes silicon and germanium, the first of the sacrificial layers has a first atomic composition at a first interface of the first of the sacrificial layers with a first of the channel material layers, the first of the sacrificial layers has a second atomic composition between the first and a second of the channel material layers, and one of the first and second atomic compositions has at least ten percent of the first or second atomic composition of germanium more than the other of the first and second atomic compositions.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
first and second channel material layers between source and drain bodies in a transistor structure;
a gate stack between the source and drain bodies, the gate stack comprising a gate metal and a gate dielectric, the gate metal between the first and second channel material layers, the gate dielectric between the gate metal and the first and second channel material layers and between the gate metal and the source and drain bodies; and
an insulator between the first and second channel material layers and between the gate dielectric and a first of the source and drain bodies, wherein the insulator has a first width between the first and second channel material layers greater than six-fifths of a second width of the insulator at an interface with the first channel material layer.

2. The apparatus of claim 1, wherein:
the first width is at a height approximately equidistant from the first and second channel material layers;
the interface of the insulator with the first channel material layer is a first interface;
a third width of the insulator is at a second interface with the second channel material layer; and
the second and third widths are approximately equal.

3. The apparatus of claim 2, wherein the second and third widths are each less than or approximately equal to a fourth width of a second insulator over an uppermost of the first and second channel material layers.

4. The apparatus of claim 2, wherein the second and third widths are each less than two-thirds of a distance between the first and second channel material layers.

5. The apparatus of claim 4, wherein the first width is less than two-thirds of the distance between the first and second channel material layers.

6. The apparatus of any one of claims 1-5, wherein:
the first width of the insulator is greater than first and second distances separating the gate metal from the first of the source and drain bodies;
the first distance is adjacent the first channel material layer and above the first width; and
the second distance is adjacent the second channel material layer and below the first width.

7. The apparatus of any one of claims 1-6, wherein a stack of nanoribbons comprises the first and second channel material layers, the insulator is a first of a plurality of insulators, the gate stack is between pairs of the plurality of insulators, and a second of the plurality of insulators is between the first and second channel material layers and between the gate dielectric and a second of the source and drain bodies.

8. A method, comprising:
removing first portions of sacrificial layers between channel material layers in a stack, the first portions comprising sidewalls of the sacrificial layers, wherein second and third portions of the sacrificial layers are retained, the second portions are between the first portions, and the third portions are adjacent interfaces of the channel material layers between the first and second portions;
forming a plurality of insulators by depositing a dielectric adjacent the second and third portions of the sacrificial layers, between the channel material layers in the stack;
exposing center portions of the channel material layers between the insulators by removing the second portions of the sacrificial layers between the third portions; and
removing the third portions adjacent the insulators and the interfaces of the channel material layers.

9. The method of claim 8, wherein the removing the third portions adjacent the insulators and the interfaces of the channel material layers exposes first sidewalls of the insulators, the first sidewalls adjacent the center portions of the channel material layers and opposite second sidewalls of the insulators adjacent end portions of the channel material layers, and further comprising recessing the first sidewalls of the insulators.

10. The method of claim 9, wherein the insulators are first insulators, and the recessing the first sidewalls of the insulators reduces a first width of a first of the first insulators to less than or approximately equal to a second width of a second insulator over an uppermost of the channel material layers.

11. The method of claim 9 or 10, wherein the recessing the first sidewalls of the insulators reduces a width of a first of the insulators to less than or approximately equal to a height of the first of the insulators between adjacent first and second channel material layers.

12. The method of any one of claims 8-11, wherein the removing the first portions of the sacrificial layers comprises etching at a first rate adjacent a centerline of a first of the sacrificial layers greater than a second rate adjacent the channel material layers.

13. The method of any one of claims 8-12, wherein the removing the third portions of the sacrificial layers comprises etching at a first rate adjacent the channel material layers greater than a second rate adjacent a centerline of a first of the sacrificial layers.

14. The method of any one of claims 8-13, further comprising depositing a gate stack between the plurality of insulators and between the channel material layers, wherein the gate stack comprises a gate metal, the depositing the gate stack deposits the gate metal to within a distance of a source or drain body, and a width of a first of the insulators between the gate metal and the source or drain body is greater than the distance.

15. The method of any one of claims 8-14, further comprising forming the stack of sacrificial layers and channel material layers, wherein a first of the sacrificial layers comprises silicon and germanium, the first of the sacrificial layers has a first atomic composition at a first interface of the first of the sacrificial layers with a first of the channel material layers, the first of the sacrificial layers has a second atomic composition between the first and a second of the channel material layers, and one of the first and second atomic compositions has at least ten percent of the first or second atomic composition of germanium more than the other of the first and second atomic compositions.
